# EUROPEAN PATENT SPECIFICATION

(11) **EP 0 763 893 B1**
(45) Date of publication and mention of the grant of the patent: **10.03.2004**
(21) Application number: 96115364.0
(22) Date of filing: 18.11.1991
(51) Int. Cl.: H03J 1/00, H04N 5/45

(54) **Device for selecting television signals**
Anordnung zum Auswählen von Fernsehsignalen
Dispositif de sélectionnement de signaux de télévision

(43) Date of publication of application: 19.03.1997
(62) Divisional of application: 91119634.3
(73) Proprietor: EDICO S.r.l., 00197 Roma (IT)
(72) Inventor: Dini, Roberto, I-10095 Rivoli (TO) (IT); Farina, Attilio, I-48016 Milano Marittima, Cervia (RA) (IT)
(74) Representative: Eisenführ, Speiser & Partner

(56) References cited:
- EP-A- 0 267 020
- EP-A- 0 360 070
- EP-A- 0 390 041
- PATENT ABSTRACTS OF JAPAN vol. 008, no. 165 (P-291), 31 July 1984 & JP-A-59 060559 (TOSHIBA KK), 6 April 1984,
- PATENT ABSTRACTS OF JAPAN vol. 008, no. 272 (E-284), 13 December 1984 & JP-A-59 141816 (MATSUSHITA DENKI SANGYO KK), 14 August 1984,

## Description

The present invention relates to a device for the selection of television signals, comprising means for the tuning of television signals, memory means for memorising the information for the relative tuning of preferred signals, and an image display means with the possibility to visualize information for the selection of said preferred signals.

A device for the selection of television signal according to the preamble of claim 1 is also known from IEEE Transactions on Consumer Electronics, 1988, August, No. 3 "An interactive menu driven remote control unit for TV-receivers an VC-recorders" whereby a cursor can be moved over field containing the station name and an allocated program member.

There are known television receivers in the prior art that have the characteristics described above.

For example, the Italian patent application No. CTA 107168, is a television receiver that can visualize on the screen a so called 'memory map', i.e., a chart on which appears the numbers of the memorised channels. As known, according to the European television system; every channel reserved to the television emissions has a number, for example in the range VHF the numbers are assigned from 2 to 12 and in the range UHF the numbers range from 21 to 69.

Such numbers however are not, in the greater part of the cases, known by the user, therefore a memory map of the type indicated is very seldom useful or practical.

The present invention takes into consideration this fact and has the aim of indicating a system more effective than those known, in facilitating the selection of the program desired on behalf of a normal user, who is not a technician.

For achieving such aims the present invention has as its object a device for the selection of television signals, with the features according to claim 1.

Further aims and advantages will become clear from the present description and annexed drawings, supplied as an explicative and non limiting example, wherein:
Figure 1 represents a block diagram of a part of circuit of a television receiver according to the invention;
Figure 2 represent the screen of a television receiver according to the invention;
Figure 3 represents a command device of the apparatus in figure 1;
Figure 4 represents a block diagram of a part of the logic control circuit of the apparatus of figure 1.

So as to provide for a simple understanding of the following description, the term "icon " has been used for the graphic symbols that represent the logotype normally used by a broadcasting station to identify itself.

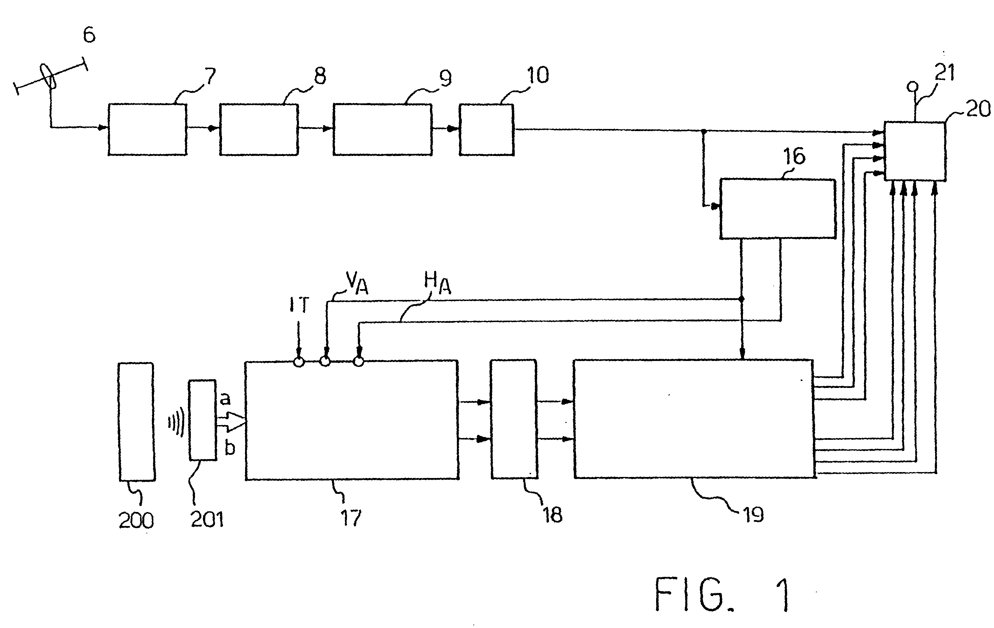

In figure 1 a block diagram represents part of the circuit of a television receiver according to the invention.

In figure 1 the reference number 6 represents a receiving antenna ; reference number 7 indicates a tuner, of the type known, that serves to tune the television signal.

Reference number 8 represents an amplifier of intermediate frequency; number 9 indicates the video detector and number 10 a pre-amplifier of a video signal.

Reference number 16 indicates a circuit that generates the vertical and horizontal synchronism signals starting from the suitable impulses contained in the video.

Reference number 200 indicates a remote control unit, for example of the usual infrared type; number 201 indicates the respective signal receiver; that is coupled to a control circuit, indicated with the reference number 17, which will be mentioned later, circuit 17 can also receive vertical and horizontal synchronism signals (VA, HA).

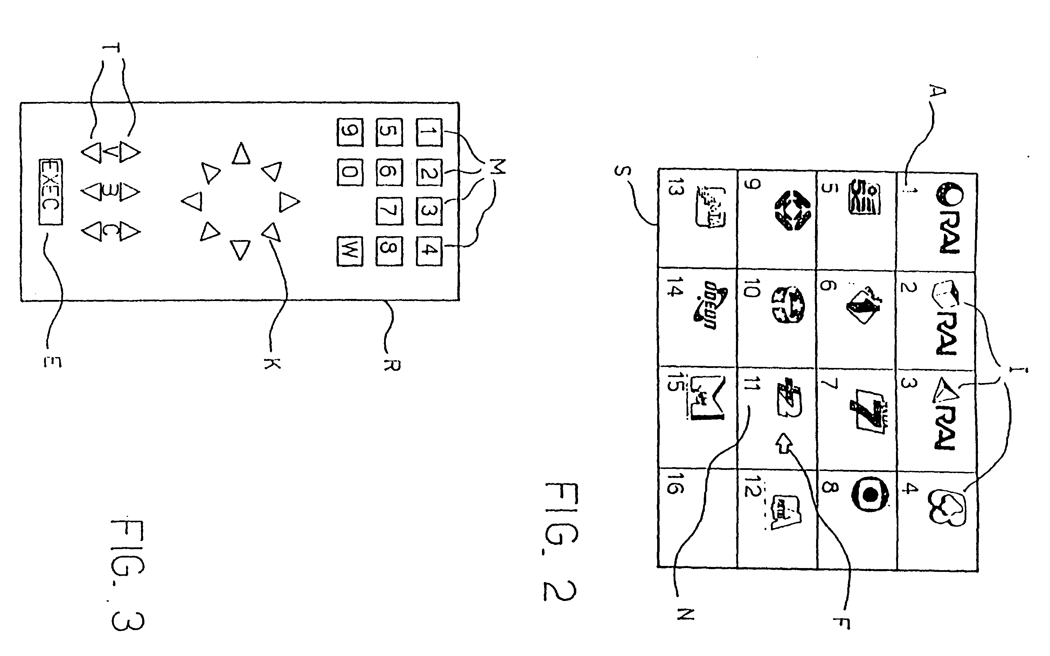

Reference number 18 indicates the clock impulse generator; 19 indicates a memory, preferably to be read and written, but in any case of the non-volatile type; such a memory serves to memorise the icons so as to carry out the image represented in figure 2.

The majority of such icons will have already been memorised in memory 19 in the place of manufacture or installation; it is however convenient to provide a special entrance for the introduction of new icons on the part of the user, when new broadcasting stations are activated, or stations already in existence changing their icon.

Such an entrance can be provided in the control circuit 17 and is indicated with the symbol IT; the use of special magnetic cards or a bar code reader, or other suitable systems can be used for the introduction of the icons.

An alternating system, that would have the advantage of consenting an easy replacement or addition of icons, is that said icons are .transmitted directly by the broadcasting station concerned, by a special teletext page; at this point the circuit 17 can be pre-arranged in order to be able to read it along with the televideo signal and to register it in a memory 19, according to the users command, or even automatically.

Naturally, it is necessary that the icon is always transmitted by the broadcasting station on a determined televideo page previously known (for example the page 799) and that the receiver is endowed with a teletext decoder; the control circuit is pre-arranged to command the decoder to read page 799, and to memorise the icon in memory 19, in the cell with the corresponding number in the tuned program (see the following information that is given in the description of the Figures 2 and 3).

In the case in which the reading and memorising of the icon are both foreseen to be controlled by the user, a special key will be provided on the remote control unit 200 or on the control panel of the receiver; in the case of automatic acquisition, circuit 17 will be prepared to obtain it at any time that the tuning of a certain program is made.

Reference number 20 indicates a commutation circuit which receives the video signal and the signals received from memory 19 ; reference number 21 indicates an output terminal with which the video signal is available containing the received television image or the image built with the assistance of the memorised icons in memory 19.

Figure 2 represents the aspect of the screen of a television receiver according to said invention; said screen is represented divided into 16 parts, but the parts could also be of a different number, greater or smaller and this would not be a determining factor.

Each part corresponds to the corresponding program received and the co-ordinates for tuning are memorised and married with a numbered key; the number of such key, i.e. the number assigned to the corresponding program, is shown in the lower left hand corner of every single part of the image (note for example reference symbols A and N).

In each division a icon is represented (1), corresponding to the "logo" of the corresponding broadcasting station; for example the three RAI networks are represented by the blue sphere, red cube and a green tetrahedron;Canale 5, the characteristic snake, and so on.

Reference symbol F represents a cursor element in the upper right hand corner of the image N° 11, with the form of an arrow (but could also be of any other form), obtained, also here by means of the prior art, superimposed on the image, or better said, on the images, as is so for the numbers A.

Such cursor element can be made more visible by making it flash, which can be done also by the use of the prior art, for example eliminating it for 5 fields and making it visible for the following 5 fields.

At this point, the number of the program could also be simply used as a marking element (A), made to flash, without having the necessity of introducing the additional element F.

In the case in which the broadcasting stations to be memorised are of a greater number than 16, or the maximum number which may be conveniently displayed by means of the icons on the screen, the icons, for example 32, can be shown by means of two successive displays; the "+" and "-" keys that are normally provided for on every remote control unit panels can be used to pass from one display to the next, in either sense.

The utilisation of the "+" and "-" keys in such a way is enabled by previously depressing key W.

Figure 3 represents a control device for the apparatus of which the screen is designed in figure 1; such device can be the transmitter of a normal infrared ray remote control unit.

In figure 3 the reference symbol R represents the remote control transmitter; the symbol M indicates a plurality of numbered keys of known functions and that obviously serve for the control of the normal functions of the apparatus; symbol T represents other usual keys, as those for the control of the volume (V), brightness (B) and colour (C).

The symbol W indicates a key that serves to show the image represented in figure 2 (icon map).

Reference symbol K indicates 8 keys that have the form of isosceles triangles, with the more pointed vertexes of which being directed externally, disposed according to the vertexes of an octagon.

Such keys serve for the moving of the cursor element F from a given icon to a contiguous one; in the case in which element F is, as indicated in figure 1, in the icon number 11, it can be moved, by means of one of the 8 keys K, in one of the 8 contiguous images (6,7,8,10,12,14,15,16), for example by depressing the key with its point at the top, the marker moves into image N° 7; pressing the key in the upper left hand corner, the marker then moves into image N° 6, and so on, in an intuitive manner. In such a way that it is easy for anybody to move the marker; by using, at the most, three movements any image can be reached starting from any point on the screen.

Once the marker has been placed in the chosen icon, it is sufficient to depress the key indicated by the symbol E (EXEC key) and the relative program will be displayed on the full screen.

This is obtained as the character generator, that generates the numbers A and eventually the marker F (in the case that the same number is not being used as a marker, made flashing), knows the co-ordinate (line and column) of the same marker, and therefore in which box of the diagram it is to be found Therefore it is sufficient to refer to the line numbers and column relative to the marker and to the number of the box, and therefore of the relative image and to give the receiver the command to select the correspondent program with such number (in practice the tuning data will be memorised in one of the correspondent boxes of the tuner's memory). instead of the eight keys K, if preferred, only one key could be used, for example having the form of an octagon or a round disc horizontally positioned and making the relative contacts function according to the way in which it is depressed. On the key, for example that of a disk form, 8 arrows could be printed to indicate the direction in which it must be depressed

One notes that to pass from a device with 4 keys to one with eight keys, i.e. to obtain also a diagonal movement that in the described case saves three movements in the case of passing from one angle of the image to the opposite angle, other contacts are not needed.

In fact, is sufficient that the 4 angle keys close both the contacts of the two adjacent keys.

In the case of a greater number of programs, the advantage of the diagonal keys is still greater: in such a case, in fact, we can save a greater number of movements.

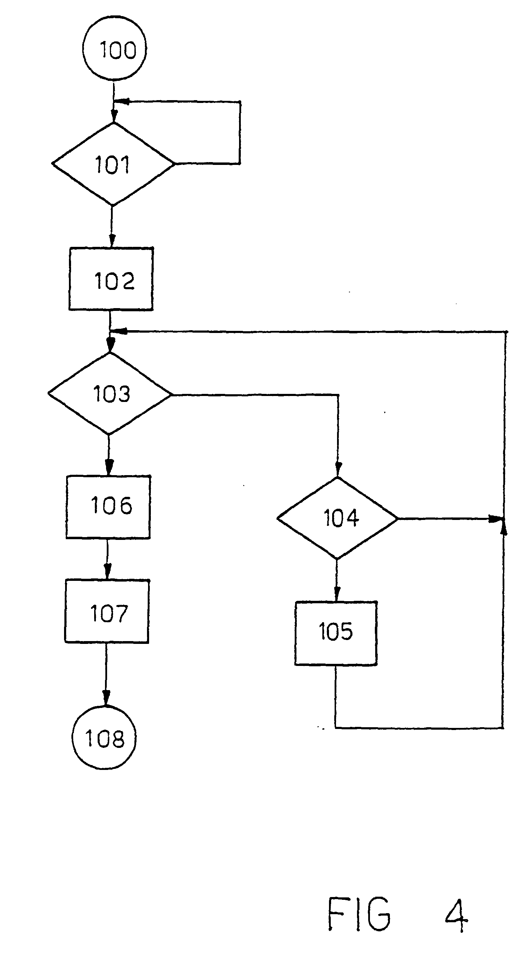

In figure 4 a block diagram of a part of the logic control circuit of the apparatus in figure 1 is represented; such a circuit, that can be incorporated in the block indicated in figure 1 with the number 17, can be indifferently made with the system of cabled logic or with a system of logic programming, i.e. utilising a microprocessor; such second system is generally less expensive, also because normally televisions and video recorders contain one or more microprocessors; the part represented in figure 4 is typical of the invention.

Block 100 is the starting block of the operations for the selection of the program.

Block 101 is a control block, it checks whether key W has been depressed; in an affirmative case control passes to block 102, in a negative case control back to the same block 101 (in all control blocks the lower exit is the YES exit whereas the side exit is the NO exit).

Block 102 shows the multiple page (icon map), in which every image corresponds to one of the 16 programs memorised by the user, with the known proceeding, in the programs memory; the numbers P are also generated, by means of a suitable character generator, and the cursor F, that is placed on the image N° 1, and is in the box on the top left hand corner of the screen. Control then passes to block 103.

Block 103 os a control block; it checks whether key E has been pressed; in an affirmative case, control passes to block 106; in a negative case, control passes back to block 104.

Block 104 is a control block; it controls whether one of the keys K has been depressed; in an affirmative case control passes to block 105; in a negative case the control passes back to block 103.

Block 105 cancels the cursor from the box in which it is to be found and makes it visible in the adjacent box depending on the particular key K depressed; then control passes back to block 103.

Block 106 identifies the box in which the marker is to be found, interrogating the state of the character generator, and calculating from the line and column number; then passing control to the successive block 107.

Block 107 supplies the appropriate operative commands to read the memory of the co-ordinate of the tuning of the corresponding program of the selected icon; to provide such a co-ordinate to tuner 7; and finally to show on all the screen the image corresponding to the television signal tuned by the tuner. Control then passes to block 108.

Block 108 is the final operations block for the selecting of the program.

The characteristics of the described apparatus result clearer from the present description and annexed drawings. The enclosed description also explains the advantages of the apparatus of said invention.

In particular they consist in the fact that it is possible for the user to select in easy and intuitive way the program that he wants to watch, moving the cursor to the corresponding icon by means of eight special keys, using at most three movements of the cursor, in the case described of 16 programs; and therefore by depressing the special key E the display on the full screen of the selected program is obtained.

It is also clear that numerous variants can be supplied by the skilled man to the display apparatus of television images described as an example, without however departing from the novelty principles inherent to the invention.

For example, rather than a key device to move the marker, a device containing a sphere could be used, to move the same marker in the direction in which the same sphere is rotated; devices of this kind are already known e.g. from JP 59 060 559.

## Claims

1. Device for the selection of television signals, comprising means for tuning television signals, a memory means for memorizing tuning information, relative to preferred signals and an image display means comprising a screen having the possibility to visualize information to facilitate the selection of said preferred signals,
**characterized in that**
said information is shown by a control unit in a form of graphic symbols arranged in a matrix said graphic symbols representing the logotype normally used by the broadcasting station to identify itself (1) in order to facilitate the tuning of one of said preferred signal said logotypes being transmitted by the broadcasting stations and being memorized in a non-volatile memory;
means (K) are provided to move a marker onto one of said graphic symbols (1), said means (K) for moving said marker (F) include a command device with a sphere and are also provided for diagonal movements for reaching one of said graphic symbol and a key is provided for displaying on the full screen the desired program related to the chosen graphic symbol.

2. Device for the selection of television signals according to claim 1, **characterized in that** said marker is composed of a luminous element (F) that appears on the screen (S).

3. Device for the selection of television signals according to claim 2, **characterized in that** said marker (F) flashes.

4. Device for the selection of television signals according to claim 2, **characterized in that** said marker (F) is in the form of an arrow.

5. Device for the selection of television signals according to claim 2, **characterized in that** said marker is represented by a number (11) made to flash.

6. Device for the selection of televisions signals according to one of the preceding claims, **characterized in that** the selection of said signals can be made by moving a special marker (F) onto the graphic symbol corresponding to the desired program and therefore activating said command key (E).

7. Device for the selection of television signals according to one of the preceding claims, **characterized in that** said key (E) generates a command signal for selecting the program corresponding to the number (N) of the market image (11) obtained based on the co-ordinate (line, column) on which the character generator, that generates such number (N), writes it on the image (11).

8. Device for the selection of television signals according to one of the preceding claims, **characterized in that** an entrance of the signals (IT) has been prearranged for memorising in said memory (19) other graphic symbols (1) and that the possibility has been provided for e direct acquisition of said graphic symbols (1) from a teletext page covered to the tuned television signal and memorise them in said memory (19), by means of a special circuit (17) pre-arranged in case of need.

9. Device for the selection of television signals according to claim 8 **characterized in that** said acquisition from a teletext page is carried out by said circuit (17) automatically, as soon as a relative television signal is tuned.

## Patentansprüche

1. Vorrichtung für die Auswahl von Femsehsignalen, mit einer Einrichtung zum Abstimmen von Fernsehsignalen, einer Speichereinrichtung zum Speichern der Abstimm-Informationen, die zu den bevorzugten Signalen gehören, und einer Bildanzeige-Einrichtung mit einem Bildschirm, mit der Möglichkeit, Informationen zur Unterstützung der Auswahl der bevorzugten Signale zu visualisieren,
**dadurch gekennzeichnet, dass**
die Information von einer Steuerungseinheit in einer Form grafischer Symbole gezeigt wird, welche in einer Matrix angeordnet sind, wobei die grafischen Symbole das Logo darstellen, welches normaler Weise von der Rundfunkstation verwendet wird, um sich zu identifizieren (1), um die Abstimmung auf eines der bevorzugten Signale zu unterstützen, wobei die Logos von den Rundfunkstationen übertragen werden und in einem nicht flüchtigen Speicher gespeichert werden;
Mittel (K) vorgesehen sind zum Bewegen einer Markierung auf eines der grafischen Symbole (1), wobei die Mittel (K) zum Bewegen der Markierung (F) eine Befehlsanordnung mit einer Kugel enthalten und ebenfalls für diagonale Bewegungen vorgesehen sind, zum Erreichen eines der grafischen Symbole, und eine Taste ist vorgesehen, um auf dem gesamten Bildschirm das zu dem ausgewählten grafischen Symbol gehörende Programm anzuzeigen.

2. Vorrichtung für die Auswahl von Fernsehsignalen nach Anspruch 1, **dadurch gekennzeichnet, dass** die Markierung aus einem leuchtenden Element (F) gebildet ist, das auf dem Bildschirm (S) erscheint.

3. Vorrichtung für die Auswahl von Fernsehsignalen nach Anspruch 2, **dadurch gekennzeichnet, dass** die Markierung (F) blinkt.

4. Vorrichtung für die Auswahl von Fernsehsignalen nach Anspruch 2, **dadurch gekennzeichnet, dass** die Markierung (F) die Form eines Pfeiles hat.

5. Vorrichtung für die Auswahl von Fernsehsignalen nach Anspruch 2, **dadurch gekennzeichnet, dass** die Markierung (F) durch eine zum Blinken gebrachte Zahl (11) dargestellt ist.

6. Vorrichtung für die Auswahl von Fernsehsignalen nach einem der vorstehenden Ansprüche, **dadurch gekennzeichnet, dass** die Auswahl der Signale ausgeführt werden kann durch Bewegen einer besonderen Markierung (F) auf das dem gewünschten Programm entsprechende grafische Symbol und Aktivieren der Befehlstaste (E).

7. Vorrichtung für die Auswahl von Fernsehsignalen nach einem der vorstehenden Ansprüche, **dadurch gekennzeichnet, dass** die Taste (E) ein Befehlssignal erzeugt zum Auswählen des Programms entsprechend der Nummer (N) des markierten Bildes (11), erhalten basierend auf der Koordinate (Zeile, Spalte), bei welcher der Zeichengenerator, der die Zahl (N) erzeugt, diese in das Bild (11) schreibt.

8. Vorrichtung für die Auswahl von Fernsehsignalen nach einem der vorstehenden Ansprüche, **dadurch gekennzeichnet, dass** ein Eintritt des Signals (IT) vorbereitet wurde, um in dem Speicher (19) andere grafische Symbole (1) zu speichern, und dass die Möglichkeit für die direkte Erfassung der grafischen Symbole (1) von einer Teletextseite vorgesehen wurde, welche vom dem abgestimmten Fernsehsignal abgedeckt wird, und Speichern dieser in dem Speicher (19) durch eine besondere Schaltung, bei Bedarf vorbestimmt.

9. Vorrichtung für die Auswahl von Fernsehsignalen nach Anspruch 8, **dadurch gekennzeichnet, dass** die Erfassung von einer Teletextseite durch die Schaltung (17) automatisch ausgeführt wird, sobald ein zugehöriges Femsehsignal abgestimmt ist.

## Revendications

1. Dispositif pour la sélection de signaux de télévision, comprenant des moyens pour régler les signaux de télévision, des moyens de mémoire pour mémoriser des informations de réglage, relatives aux signaux préférés et des moyens d'affichage d'image comprenant un écran présentant la possibilité de visualiser les informations afin de faciliter la sélection desdits signaux préférés,
**caractérisé en ce que**
lesdites informations sont représentées par une unité de contrôle sous forme de symboles graphiques agencés en grille, lesdits symboles graphiques représentant le logo qui est normalement utilisé par la station de diffusion afin de l'identifier (1) afin de faciliter le réglage de l'un desdits signaux préférés, lesdits logos étant transmis par les stations de diffusion et étant mémorisés dans une mémoire non volatile ; des moyens (K) sont fournis pour déplacer un marqueur dans un desdits symboles graphiques (1), lesdits moyens (K) permettant de déplacer ledit marqueur (F) comprenant un dispositif de commande avec une sphère et sont également fournis pour des mouvements en diagonale pour atteindre l'un desdits symboles graphiques et une clé est fournie pour afficher en plein écran le programme souhaité relatif au symbole graphique choisi.

2. Dispositif pour la sélection de signaux de télévision selon la revendication 1, **caractérisé en ce que** ledit marqueur est composé d'un élément lumineux (F) qui apparaît sur l'écran (S).

3. Dispositif pour la sélection de signaux de télévision selon la revendication 2, **caractérisé en ce que** ledit marqueur (F) clignote.

4. Dispositif pour la sélection de signaux de télévision selon la revendication 2, **caractérisé en ce que** ledit marqueur (F) est en forme de flèche.

5. Dispositif pour la sélection de signaux de télévision selon la revendication 2, **caractérisé en ce que** ledit marqueur est représenté par un numéro (11) qui clignote.

6. Dispositif pour la sélection de signaux de télévision selon l'une quelconque des revendications précédentes, **caractérisé en ce que** la sélection desdits signaux peut être effectuée en déplaçant un marqueur spécial (F) sur le symbole graphique correspondant au programme souhaité et, par conséquent, en activant ladite clé de commande (E).

7. Dispositif pour la sélection de signaux de télévision selon l'une quelconque des revendications précédentes, **caractérisé en ce que** ladite clé (E) génère un signal de commande pour sélectionner le programme correspondant au numéro (N) de la représentation marquée (11) obtenu à partir des coordonnées (ligne, colonne) sur lesquelles se base le générateur de caractères qui produit ledit numéro (N) pour l'inscrire sur la représentation (11).

8. Dispositif pour la sélection de signaux de télévision selon l'une quelconque des revendications précédentes, **caractérisé en ce qu'**une entrée de signaux (IT) a été agencée au préalable afin de mémoriser dans ladite mémoire (19) d'autres symboles graphiques (1) et **en ce qu'**il a été offert la possibilité d'effectuer l'acquisition directe desdits symboles graphiques (1) à partir d'une page de télétexte couplée au signal de télévision réglé et de les mémoriser dans ladite mémoire (19) au moyen d'un circuit spécial (17) agencé au préalable en cas de besoin.

9. Dispositif pour la sélection de signaux de télévision selon la revendication 8, **caractérisé en ce que** ladite acquisition provenant d'une page de télétexte est réalisée automatiquement par ledit circuit (17) dès que le signal de télévision relatif est réglé.
